(19) Europäisches Patentamt
European Patent Office
Office européen des brevets

(11) **EP 3 540 795 A1**

(12) **EUROPEAN PATENT APPLICATION**

(43) Date of publication:
**18.09.2019 Bulletin 2019/38**

(51) Int Cl.:
**H01L 39/14** (2006.01)    **H01L 39/24** (2006.01)

(21) Application number: **18161977.6**

(22) Date of filing: **15.03.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Bruker HTS GmbH**
**63450 Hanau (DE)**

(72) Inventors:
• **Usoskin, Alexander**
**63456 Hanau (DE)**
• **Betz, Ulrich**
**63755 Alzenau (DE)**

(74) Representative: **Kohler Schmid Möbus**
**Patentanwälte**
**Partnerschaftsgesellschaft mbB**
**Gropiusplatz 10**
**70563 Stuttgart (DE)**

(54) **A TAPE TYPE SUPERCONDUCTOR WITH A PLURALITY OF ELONGATED BARRIER STRUCTURES**

(57)    A tape type superconductor (1), extending along a longitudinal direction (LD), comprising
- a substrate tape (2),
- at least one buffer layer (3), and
- a superconductor layer (4),
said superconductor layer (4) having a width $W_{SL}$ in a width direction (WD), with the width direction (WD) being perpendicular to the longitudinal direction (LD) and being parallel to a substrate tape (2) flat side (8),
and said tape type superconductor (1) having a length $L_{TTS}$ in longitudinal direction (LD), is characterized in that the tape type superconductor (1) comprises a plurality of elongated barrier structures (5, 5a, 5b) which are oriented in parallel with the longitudinal direction (LD),
wherein a respective barrier structure (5, 5a, 5b) has a length $L_{BS}$ in longitudinal direction (LD), with $L_{BS} \geq 0.20*W_{SL}$ and $L_{BS} \leq 0.20*L_{TTS}$,
that the barrier structures (5, 5a, 5b) are arranged distributed along the longitudinal direction (LD),
and that the barrier structures (5, 5a, 5b) are located at least partially in the superconductor layer (4) and impede a superconducting current flow in width direction (WD) across a respective barrier structure (5, 5a, 5b). The invention provides a tape type superconductor, with which high critical currents may be achieved in a simple way over extended tape lengths with suppressed magnetization.

Fig. 1a

**Description**

The invention relates to a tape type superconductor, extending along a longitudinal direction, comprising

- a substrate tape,
- at least one buffer layer, and
- a superconductor layer,

said superconductor layer having a width $W_{SL}$ in a width direction,

with the width direction being perpendicular to the longitudinal direction and being parallel to a substrate tape flat side, and said tape type superconductor having a length $L_{TTS}$ in longitudinal direction.

Such tape type superconductor is known from US 2007/0191202 A1.

Superconductors can be used to carry an electric current at practically no ohmic losses, for example in order to produce high strength magnetic fields in superconducting magnet coils, or simply to transport the current from a source to a consumer. Superconductor materials have to be cooled to cryogenic temperatures in order to assume superconductivity. While low temperature superconductors (=LTS) such as NbTi are in general metallic and therefore can be prepared easily for example as drawn wires, high temperature superconductors (=HTS) such as YBCO are in general ceramic and therefore are often prepared as tape type superconductors to compensate for the brittle characteristics of the ceramic HTS.

Tape type superconductors typically comprise a substrate of preferably flexible material such as steel, covered with at least one buffer layer and a superconductor layer. Manufacturing of a HTS coated tape is for example described in EP 2 490 273 A1.

Tape type superconductors are difficult to prepare at high quality, in particular over an extended length. In particular, local defects in the superconductor layer may deteriorate the achievable critical current. When transporting AC currents, significant AC losses due to eddy currents may occur. More generally, induced superconducting closed loop shielding currents store energy in the tape type superconductor, and generate magnetic moments. The magnetization may decrease the conductor stability, i.e. the risk of a sudden loss of superconductivity ("quench") may rise. Further, magnetization may lead to field oscillations, deteriorating measurements such as NMR measurements performed with a magnetic coil using the tape type superconductor.

In order to reduce AC losses, EP 2 144 255 A1 proposes a superconducting cable having a channel for cooling liquid and a tubular support structure, wherein high Tc superconductors are arranged in two layers using different high Tc materials, and having normal-conducting interruptions in the high Tc conductors of the outer layer.

US 2007/0191202 A1 proposes a superconducting tape with a segmented HTS layer. Disruptive strips are formed in one of the tape substrate, a buffer layer, and a superconducting layer, and create parallel discontinuities in the superconductor layer, which reduces AC losses.

In this design, the superconductor layer is formed of parallel superconducting filaments. While this works well for relatively short tape lengths, for more extended tape lengths local defects in the superconductor filaments become more probable, which can make an affected superconducting filament useless. Therefore, good critical currents are difficult to achieve for more extended tape lengths.

US 9,786,415 B2 proposes a high temperature superconductor tape including a plurality of superconducting filaments, to improve a transverse tensile strength. The filaments may be produced by removing portions of a superconductive layer.

US 2017/0287599 A1 proposes a superconducting wire with a base material, an intermediate layer, and an oxide superconducting layer. The intermediate layer comprises non-orientation regions extending in a longitudinal direction of the base material, which lead to non-orientation regions in the oxide superconducting layer, too, which have no superconducting characteristics or a significantly lower critical current.

DE 10 2009 038 920 A1 proposes a multifilament conductor, wherein superconducting filaments are inclined with respect to a longitudinal direction of the multifilament conductor. The filaments are wound about a substrate. The multifilament conductor has decreased electric losses, and minimizes inductance of currents in external alternating fields. In one embodiment, bridges are provided between neighbouring wound filaments.

The filaments wound about the substrate are difficult to produce and come along with currents flowing in a screw like fashion, what generates magnetic fields along the screw axis, which are generally undesired. Further, using the bridges between neighbouring wound filaments may require current flow against the overall flow direction, which deteriorates the achievable magnetic field strength.

Object of the invention

It is the object of the invention to present a tape type superconductor, with which high critical currents may be achieved in a simple way over extended tape lengths with supressed magnetization.

<u>Short description of the invention</u>

This object is achieved, in accordance with the invention, by a tape type superconductor as introduced in the beginning,
characterized in
that the tape type superconductor comprises a plurality of elongated barrier structures which are oriented in parallel with the longitudinal direction,
wherein a respective barrier structure has a length $L_{BS}$ in longitudinal direction, with $L_{BS} \geq 0.20*W_{SL}$ and $L_{BS} \leq 0.20*L_{TTS}$,
that the barrier structures are arranged distributed along the longitudinal direction,
and that the barrier structures are located at least partially in the superconductor layer and impede a superconducting current flow in width direction across a respective barrier structure.

By means of the inventive tape type superconductor, high electrical currents may be transported along the longitudinal direction (or tape direction) superconductively. In particular, the barrier structures extending in parallel to the longitudinal direction do not hinder the transport of the electrical current in this longitudinal direction in the superconductor layer. Further note that no currents turned around the substrate tape are established.

Further, less energy is stored in the form of magnetization. The tape type superconductor is more stable against quenches, and also field oscillations (that might deteriorate NMR measurements, for example) are reduced. The reduction in magnetization is achieved in spite of the limited length of the barrier structures in longitudinal direction and their arrangement distributed in longitudinal direction.

In order to have a good protection against shielding currents, the invention proposes a minimum length $L_{BS}$ of the barrier structures as compared to the (overall) superconductor layer width $W_{SL}$, with $L_{BS} \geq 0.20 \, W_{SL}$.

In accordance with the invention, the barrier structures are significantly shorter than the length $L_{TTS}$ of the tape type superconductor, with $L_{BS} \leq 0.20 \, L_{TTS}$. This allows a circumvention of possible local defects in the superconductor layer. The superconducting current may, if needed, flow in width direction ("transverse flow") in front of and behind a barrier structure, and thus switch to an area in width direction not affected by a local defect in the superconductor layer. The switching of the superconductive current in width direction is easy and does not require any effective back currents, since the barrier structures extend in parallel with the longitudinal direction.

The electric current flow in width direction may be controlled by a non-linear conductivity of intermediate regions of superconductor layer material which precede and follow barrier structures in width direction; the intermediate regions typically form narrow gaps between each two barrier structures which are at the same position in width direction and which are subsequent in longitudinal direction. The intermediate regions form superconductive links between areas of the superconductor layer which are adjacent in width direction. These superconductive links are relatively weak, though. The superconductive links may easily be overloaded with shielding currents which are responsible for a coupling of said adjacent areas. Therefore, in high magnetic fields, the intermediate regions tend to be at normally conducting state, and due to this normally conducting state, shielding currents responsible for coupling of said adjacent areas are suppressed. However, if a non-superconductive defect is present in one of said adjacent areas, the coupling shielding currents are at a lower level in the vicinity of the defect. Therefore, the neighbouring intermediate regions may carry additional current helping in bypassing the defect. This behavior results in a self-adjusting cross-coupling between said adjacent areas of the superconductor film, and may allow for a further increase in the usable length of the inventive tape-type superconductor.

Further, the barrier structures are simple to produce, in particular over long lengths, since they are in parallel with the extension direction. In the most simple case, the tape type superconductor may be treated during a winding the tape in order to establish the barrier structures, with a tool or tools located at a constant position in width direction.

Note that the substrate tape of an inventive tape type superconductor is in general only covered with a superconductor layer on one of its flat sides. Typically, there is also a metallic coating covering the superconductor layer (and also the barrier structures). The substrate tape is typically polished before depositing a buffer layer and the superconductor layer.

Note that typically $L_{BS} \leq (10^{-3})*L_{TTS}$ or even $L_{BS} \leq (10^{-5})*L_{TTS}$, and further typically $L_{TTS} \geq 10m$ or even $L_{TTS} \geq 100m$. The width $W_{SL}$ of the superconducting layer (and also the width of the tape type superconductor in general) is typically from 1.5 mm to 2 cm, and often from 2.5 mm to 1.0 cm. A typical length $L_{BS}$ is from 2.0 mm to 2.5 cm, and often from 3.0 mm to 1.5 mm. In general, the barrier structures are also arranged distributed in width direction. The arrangement of barrier structures is preferably non-periodic along the longitudinal direction (or tape direction). However, a periodic arrangement of the barrier structures is also possible, in particular with a period P much longer than the (average) length $L_{BS}$, such as $P \geq 5*L_{BS}$.

Typically, all barrier structures have a uniform length $L_{BS}$. However, it is also possible to have a distribution of barrier structure lengths in the tape type superconductor. Structures having dimensions not covered by the defined requirements (see above) are not considered as barrier structures in the sense of the present invention.

<u>Preferred embodiments of the invention</u>

In a preferred embodiment of the inventive tape type superconductor, a respective barrier structure stretches across the complete height $H_{SL}$ of a the superconductor layer in a height direction, with the height direction being perpendicular to the longitudinal direction and being perpendicular to the substrate tape flat side. This provides a maximum impediment for a superconducting current in width direction at the barrier structure, and thus optimum protection against undesired shielding currents or magnetization, and is simple to produce.

Particular preferred is an embodiment wherein the barrier structures are non-superconducting or exhibit a critical current density $j_c^{BS}$ in width direction which is less than 1/100 of a critical current density $j_c^{SL}$ in width direction of a superconducting material of the superconductor layer. This makes sure that superconductive shielding currents across the barrier structures can be excluded or at least kept significantly weaker than a (regular) longitudinal superconductive current.

In an advantageous embodiment, the barrier structures are spaces filled with a non-superconducting material of a different chemical composition as compared to the superconducting material of the superconductor layer,
in particular wherein the spaces are filled with a non-superconducting metal. Establishing a different chemical structure in the spaces is a simple and highly reliable measure for implementing a barrier structure. Typically, the spaces are first made by removing material from a (closed) superconductor layer, and then the resultant gaps are filled with the non-superconducting material. Metals are particularly simple to use for the latter purpose. Alternatively, a chemical composition can be changed locally e.g. by ion bombardment. This embodiment typically includes a post treatment of a (continuous) superconductor layer.

In an alternative embodiment, the barrier structures have the same chemical composition as the superconducting material of the superconductor layer, but exhibit deviations from the phase composition and/or exhibit disturbances in the crystalline structure as compared to the superconducting material of the superconductor layer. The barrier structures are typically established by treating the substrate tape or a buffer layer at locations where barrier structures are desired ("disturbance pattern"), before depositing the superconductor layer. The superconducting material only assumes the superconducting phase away from the disturbance pattern. then no post treatment of a superconductor layer is needed. However, it is also possible to alter the chemical (or elemental) composition e.g. by a local heat treatment.

In a highly preferred embodiment, at least 80%, preferably at least 90%, of the length $L_{TTS}$ of the tape type superconductor is overlapped by barrier structures. In this way, a high level of protection against undesired shielding currents and magnetization in the superconductor layer can be achieved.

Particularly preferred is a further development of this embodiment, wherein 100% of the length $L_{TTS}$ of the tape type superconductor is overlapped by barrier structures. This establishes an even better protection against undesired shielding currents and magnetization.

In a preferred embodiment, at least 80%, preferably at least 90%, of the length $L_{TTS}$ of the tape type superconductor is overlapped by at least n barrier structures which are sequent in width direction, with $n \geq 2$. Preferably, 100% of the length $L_{TTS}$ of the tape type superconductor is overlapped by at least n barrier structures which are sequent in width direction, with $n \geq 2$. With more overlapping barrier structures, a finer limitation of spaces in width direction for shielding currents may be achieved, what helps to reduce undesired magnetization further.

In a particularly preferred embodiment for an average barrier density ABD, which is defined as a local barrier density of the tape type superconductor averaged along the complete length $L_{TTS}$, with the local barrier density being the number of barrier structures intersected by a cross section of the tape type superconductor perpendicular to the longitudinal direction at a local position in longitudinal direction, the following applies

$$ABD \geq 0.80,$$

preferably ABD>1.0,
most preferably $ABD \geq 2.0$. With a high average barrier density, a high level of protection against shielding currents or magnetization, respectively, can be achieved. Note that often ABD>2.0 also applies. Note further that often $ABD \leq 4$ applies.

A preferred further development of this embodiment provides that

- $ABD \leq 2.5$ and $W_{SL} / (2*ABD) \leq L_{BS}$, and/or
- $ABD \leq 250$ and $L_{BS} \leq (50 / ABD)*W_{SL}$, and/or
- $ABD \leq 5$ and $W_{SL} / ABD \leq L_{BS}$, and/or
- $ABS \leq 125$ and $L_{BS} \leq (25 / ABD)*W_{SL}$. With these parameters, the density of barrier structures is typically adequate for a good protection against undesired magnetization, and for not being prone to local defects in the superconductor layer. Also preferred is $W_{SL} / (ABD+1) \leq L_{BS}$, for $ABD \leq 4$.

In another advantageous further development, the barrier structures are arranged distributed over at least m different positions in width direction,
with $m > 2*ABD$ or $m > 3*ABD$,
in particular wherein on average over the length $L_{TTS}$, the barrier structures are basically equally distributed over the at least m different positions in width direction. In this case, the barrier structures may be put at a variety of different positions, in particular more different positions than necessary for achieving the given average barrier density ABD. In this way, the barrier structure distribution may be more versatile, and in particular random patterns may be established easily, which are less prone to quenches and undesired magnetic field components than regular or periodic patterns. Preferably, the at least m different positions are basically equally distributed in width direction.

In a preferred embodiment, $0.25*W_{SL} \leq L_{BS}$ and/or $L_{BS} \leq 25*W_{SL}$,
preferably with $0.5*W_{SL} \leq L_{BS}$ and/or $L_{BS} \leq 12.5*W_{SL}$. Often also $L_{BS} \leq 5*W_{SL}$ applies. With these parameters again, the dimensions of barrier structures are typically adequate for a good protection against undesired magnetization, and for not being prone to local defects in the superconductor layer.

Preferred is further an embodiment wherein the barrier structures have an aspect ratio $AR_{BS}=L_{BS}/W_{BS}$, with $AR_{BS} \geq 10$, preferably $AR_{BS} \geq 20$, with $W_{BS}$: width of a respective barrier structure in width direction. Typically there is also $AR_{BS} \leq 5500$, in particular $AR_{BS} \leq 100$. Note that $W_{BS}$ is typically about $25\mu m$ through $250\mu m$. These dimensions are both easy to produce and offer a high protection against undesired increased shielding currents or magnetization, respectively.

In a preferred embodiment, the superconducting material of the superconductor layer is a high temperature superconductor, in particular REBCO or BiSCCO or $MgB_2$. On the inventive tape type superconductor, in particular with a flexible substrate tape, these brittle materials may be handled safely and used for typical applications such as superconducting coils, for example as magnets in NMR (nuclear magnetic resonance) apparatus.

Also preferred is an embodiment wherein the substrate tape is made of metal, in particular stainless steel or Hastelloy. Metal substrate tapes are safe to handle, in particular for winding coils. Alternatively, the substrate tape can be made, for example, of a ceramic material. Note that in general, the substrate tape (and the tape type superconductor as a whole) is preferably flexible.

*Methods for producing inventive tape type superconductors*

Also within the scope of the present invention is a method for producing an inventive tape type superconductor, wherein the barrier structures are spaces filled with a non-superconducting material of a different chemical composition as compared to the superconducting material of the superconductor layer, characterized in that

- at least one continuous buffer layer is deposited on the substrate tape,
- a continuous superconductor layer is deposited on the at least one continuous buffer layer,
- at locations intended for barrier structures, the superconducting material of the superconductor layer is locally removed, in particular by laser etching, thus forming grooves reaching at least to the at least one buffer layer,
- and the grooves are filled with the non-superconducting material of a different chemical composition as compared to the superconducting material of the superconductor layer. This is a simple and highly reliable method for implementing the barrier structures. The non-superconducting material may be a metal, for example a metal also used for a protective layer or shunt layer.

Alternatively, in accordance with the invention, there is a method for producing an inventive tape type superconductor wherein the barrier structures are spaces filled with a non-superconducting material of a different chemical composition as compared to the superconducting material of the superconductor layer, characterized in that

- at least one continuous buffer layer is deposited on the substrate tape,
- a continuous superconductor layer is deposited on the at least one continuous buffer layer,
- at locations intended for barrier structures, the superconducting material of the superconductor layer is locally converted into the non-superconducting material of a different chemical composition as compared to the superconducting material of the superconductor layer, in particular by ion bombardment. This method produces less dirt in general, since no removal of material is necessary, but typically takes long time for thorough material conversion.

Further within the scope of the present invention is a method for producing an inventive tape type superconductor, wherein the barrier structures have the same chemical composition as the superconducting material of the superconductor layer, but exhibit deviations from the phase composition and/or exhibit disturbances in the crystalline structure as compared to the superconducting material of the superconductor layer, characterized in that

- at locations intended for barrier structures,

    a) a surface of a buffer layer deposited on the substrate tape is locally disturbed, in particular by scratching or laser etching, thus forming a disturbance pattern, or
    b) a surface of a substrate tape is locally disturbed, in particular by scratching or laser etching, thus forming a disturbance pattern, and a buffer layer is deposited on the substrate tape,

- and material is deposited on the buffer layer, wherein the superconducting material of the superconductor layer forms everywhere on the buffer layer but on the disturbance pattern. In this method, no post-treatment of the superconductor layer is necessary for establishing the barrier structures, what reduces the risk of damages (such as introducing defects, or lowering the critical current density in general) into the superconductor layer. Note that disturbing the surface typically occurs via implementing an increased surface roughness, but may also include implementing a surface inclination (e.g. > 2°) as compared to the undisturbed surface.

Alternatively, in accordance with the invention, there is a method for producing an inventive tape type superconductor, wherein the barrier structures have the same chemical composition as the superconducting material of the superconductor layer, but exhibit deviations from the phase composition and/or exhibit disturbances in the crystalline structure as compared to the superconducting material of the superconductor layer, characterized in that

- at least one continuous buffer layer is deposited on the substrate tape,
- a continuous superconductor layer is deposited on the at least one continuous buffer layer,
- at locations intended for barrier structures, the superconducting material of the superconductor layer is locally treated, imposing a new phase composition and/or disturbances in the crystalline structure without changing the chemical composition, in particular by local heating. This method is particularly simple during deposition, but requires very careful local treatment in order to reliably establish a non-superconducting material (or a superconducting material with significantly worse critical current than the superconducting material of the superconductor layer) by the treatment in the desired design.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

Drawing

The invention is shown in the drawing.

Fig. 1a        shows a schematic top view of a first embodiment of an inventive tape type superconductor, with barrier structures at one width position, subsequent along the longitudinal direction;

Fig. 1b        a schematic cross-section of the superconductor of Fig. 1a at plane Ib;

Fig. 1c        a schematic cross-section of the superconductor of Fig. 1a at plane Ic;

Fig. 2a        shows a schematic top view of a second embodiment of an inventive tape type superconductor, with barrier structures at two width positions, subsequent along the longitudinal direction;

Fig. 2b        a schematic cross-section of the superconductor of Fig. 2a at plane IIb;

Fig. 2c        a schematic cross-section of the superconductor of Fig. 2a at plane IIc;

Fig. 2d        a schematic cross-section of the superconductor of Fig. 2a at plane IId;

Fig. 3         shows a schematic top view of a third embodiment of an inventive tape type superconductor, with barrier structures at three width positions, with periodically arranged barrier structures;

Fig. 4          shows a schematic top view of a fourth embodiment of an inventive tape type superconductor, with barrier structures at three width positions, with barrier structures of variable length arranged in a random pattern;

Fig. 5          shows a schematic top view of a fifth embodiment of an inventive tape type superconductor, with barrier structures at five width positions, with barrier structures of fixed length arranged in a random pattern;

Fig. 6a-6f      a schematic sequence of cross-sections illustrating a first variant of a method for producing of an inventive tape type superconductor, including a laser etching of grooves in a superconductor layer;

Fig. 7a-7c      a schematic sequence of cross-sections illustrating a second variant of a method for producing of an inventive tape type superconductor, including an ion bombardment of regions of a superconductor layer;

Fig. 8a-8d     a schematic sequence of cross-sections illustrating a third variant of a method for producing of an inventive tape type superconductor, including scratching of a buffer layer;

Fig. 9a-9c     a schematic sequence of cross-sections illustrating a fourth variant of a method for producing of an inventive tape type superconductor, including local heating of regions of a superconductor layer.

It should be noted that the figures are schematic in nature, and some features may be shown in an exaggerated or understated way, in order to show particular features of an inventive tape type superconductor or an inventive production method more clearly.

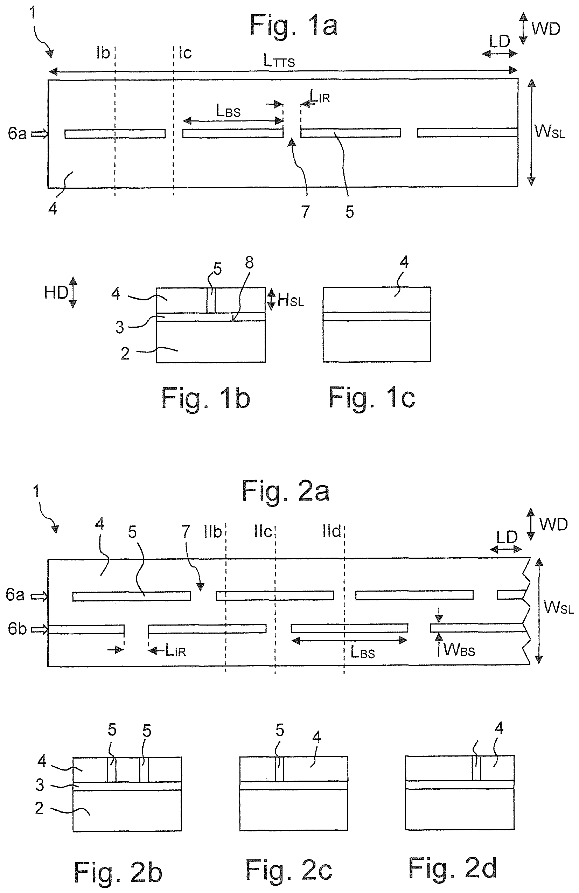

**Fig. 1a** shows a first embodiment of an inventive tape type superconductor 1 in a schematic top view. **Figs. 1b** and **1c** illustrate cross-sectional views of said tape type superconductor 1 perpendicular to the longitudinal direction LD at positions of planes Ib and Ic.

The tape type superconductor 1 comprises a substrate tape 2, which is flexible so it can be wound for example into a solenoid type coil, further at least one buffer layer 3 deposited on a flat side 8 of the substrate tape 2, and a superconductor layer 4 deposited on top of the at least one buffer layer 3. Typically, the superconductor layer 4 is further covered with a metallic protection layer or shunt layer (not shown), for example made of a noble metal such as silver or made of copper. The superconductor layer 4 is made of a superconducting material, typically a high temperature superconductor material of ceramic type such as YBCO.

Further, the tape type superconductor 1 includes a plurality of barrier structures 5 extending in parallel (within the manufacturing accuracy) to the longitudinal direction LD. The barrier structures 5 extend over the complete height $H_{SL}$ of the superconductor layer 4 in a height direction HD (which runs perpendicular to the flat side 8). The barrier structures 5 are filled with a material that is non-superconducting, such as a metal, or filled with a material with significantly worse superconducting characteristics as compared to the superconducting material of the superconductor layer 4, for example with a critical current density lower by a factor of more than 100 (at the same temperature and magnetic field strength during operation). Note that preferably, the material of the barrier structures 5 is normally conductive, with an electrical conductivity corresponding to the conductivity of copper or better (at operating temperature, such as at 4.2 K). The barrier structures 5 are separate from each other, such that in general, each barrier structure 5 is surrounded by superconducting material of the superconductor layer 4 in width direction WD and longitudinal direction LD (with the exception of end faces of barrier structures 5 at an end of the tape type superconductor 1, see here right end in Fig. 1a).

The tape type superconductor 1 is intended for transporting an electric current superconductingly along the longitudinal direction LD.

In the example shown, the barrier structures 5 have a uniform length $L_{BS}$ in longitudinal direction LD, the overall tape type superconductor 1 has a length $L_{TTS}$ in longitudinal direction LD, and the superconductor layer 4 has a constant width $W_{SL}$ (which is here identical to a width of the tape type superconductor 1 in general) in width direction WD. The barrier structures 5 are arranged subsequent in longitudinal direction LD, and are all arranged at the same position 6a (m=1) in width direction, with said position 6a being in the middle of the tape type superconductor 1 with respect to the width direction WD. Between each two neighboring barrier structures 5 in the sequence, there is an intermediate region 7 belonging to the superconductive layer 4, and therefore with the superconductive characteristics of the superconducting material of the superconductor layer 4. At the intermediate regions 7, a superconducting current may flow between an (in Fig. 1a) upper part and a lower part of the superconductor layer 4. The intermediate regions 7 here have a uniform length of $L_{IR}$ in longitudinal direction LD. In other words, the barrier structures 5 here form a regular "dashed line" pattern in the superconductor layer 4.

In the example shown, the following roughly applies:

a) $L_{BS} = 0.20*L_{TTS}$; note that typically $L_{TTS}$ is much longer than shown in the example, so often $L_{BS} \leq 0.001*L_{TTS}$, for example;

b) $L_{BS} = 0.92*W_{SL}$;

c) $L_{IR} = 0.17*L_{BS}$; note that this means here that about 86% of the entire length $L_{TTS}$ is overlapped by barrier structures 5, and an average barrier density ABD is about 0.86 in this case.

The barrier structures 5 separate the superconductor layer 4 into an (in Fig. 1a) upper part and a lower part where areas for particular shielding currents are reduced. When m>1, they are even more reduced with consequent suppression of shielding currents and related magnetization. Thus, in case shown in Fig. 1a, the invention provides a decoupling of regions in the superconductor layer 4 at opposing sides of a respective barrier structure 5 ("adjacent areas"). On the other hand, at the intermediate regions 7 a current exchange (i.e. partial coupling) may take place. This coupling represents a non-linear effect which allows more homogeneous distribution of the entire transport current in the entire cross-section (width) of the tape.

In the following, further embodiments of inventive tape type superconductors 1 are explained, and only the major differences with respect to the embodiment shown in Figs. 1a-1c are discussed in more detail.

**Fig. 2a** in top view and **Figs. 2b, 2c** and **2d** in cross-sectional views at the positions of planes IIb, IIc and IId show a second embodiment of an inventive tape type superconductor 1. Note that the end at the right hand side of the tape type superconductor 1 is shown abbreviated in Fig. 2a here.

In this embodiment, barrier structures 5 of uniform length $L_{BS}$ are located at two positions 6a, 6b (m=2) in width direction WD; note that in general, embodiments wherein the barrier structures 5 are distributed over a plurality of positions in width direction WD (i.e. m≥2) are generally preferred, so shielding currents may be more limited in space in width direction WD, in order to achieve a lower magnetization. At each position 6a, 6b, barrier structures 5 are arranged subsequent in longitudinal direction LD, with intermediate regions 7 of uniform length $L_{IR}$ between barrier structures 5 neighboring in longitudinal direction LD.

The intermediate regions 7 of positions 6a and 6b are displaced in longitudinal direction such that they do not mutually overlap. Seen the other way, the barrier structures 5 of positions 6a and 6b are displaced in longitudinal direction such that they do mutually overlap, here at both ends. As a result, all of the length $L_{TTS}$, i.e. 100%, are overlapped by at least one barrier structure 5. Figs. 2c, 2d illustrate the situations with one barrier structure 5 in cross-section, which here applies over about 35% of the length $L_{TTS}$. Fig. 2b illustrates the situation with two barrier structures 5 in cross-section, which here applies about 65% of the length $L_{TTS}$. This results in an average barrier density ABD of (0.35*1)+(0.65*2)=1.59 for the illustrated tape type superconductor 1. In the example shown, approximately $L_{BS} = 1.07*W_{SL}$ and further $L_{IR} = 0.21*L_{BS}$ applies.

In general it is preferred that

$$L_{IR} \geq 0.25*W_{SL}/(m+1) \text{ and/or } L_{IR} \leq 4*W_{SL}/(m+1),$$

preferably $L_{IR} \geq 0.5*W_{SL}/(m+1)$ and/or $L_{IR} \leq 2*W_{SL}/(m+1)$, with m: number of positions in width direction over which the barrier structures 5 are distributed. Often $L_{IR} \leq W_{SL}$ is also preferred, and often $L_{IR} \leq W_{SL}/4$ or even $L_{IR} \leq W_{SL}/10$ also applies.

The positions 6a, 6b are basically equally distributed over the width $W_{SL}$ of the superconductor layer 4 or of the tape type superconductor 1, respectively. The barrier structures 5 have an aspect ratio $AR_{BS}=L_{BS}/W_{BS}$, with $W_{BS}$ being the width of the barrier structure 5 in width direction WD, and with here approximately $AR_{BS}=14$; note that in general, aspect ratios $AR_{BS}$ of 10 or more, or even 20 or more are preferred.

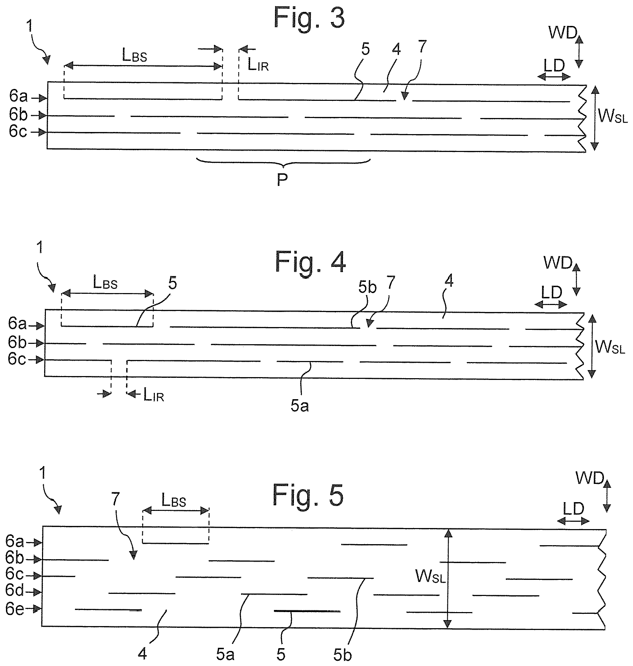

**Fig. 3** illustrates a third embodiment of an inventive tape type superconductor 1, wherein the barrier structures 5 having a uniform length $L_{BS}$ are distributed equally over three positions 6a, 6b, 6c (i.e. m=3) in width direction WD. Again, the barrier structures 5 at each position 6a-6c are arranged one behind the other, separated by intermediate regions 7 of uniform length $L_{IR}$.

In the example shown, the following approximately applies:

a) $L_{BS} = 2.38*W_{SL}$;

b) $L_{IR} = 0.11*L_{BS}$; since the intermediate regions 7 do not overlap, this results in an average barrier density ABD of [3*0.11*2+(1.11-3*0.11)*3]/(1.11)=2.70.

In this embodiment, the barrier structures 5 are arranged periodically with respect to the longitudinal direction LD, here with a period P corresponding to the entirety of one barrier structure 5 and one adjacent intermediate region 7, and here with approximately $P=2.63*W_{SL}$.

**Fig. 4** illustrates in a fourth embodiment a tape type superconductor 1 similar to the embodiment shown in Fig. 3, so only the major differences are discussed.

In the fourth embodiment, the barrier structures 5 have a variable length $L_{BS}$. However, intermediate regions 7 between barrier structures subsequent in longitudinal direction at the same position 6a-6c have a uniform length $L_{IR}$ in longitudinal direction LD.

In the example shown, the barrier structure 5a has the shortest length $L_{BS}^{short}$, for which applies here approximately $L_{BS}^{short} = 1.0*W_{SL}$, and the barrier structure 5b has the longest length $L_{BS}^{long}$, for which applies here approximately $L_{BS}^{long} = 2.9*W_{SL}$. The lengths $L_{BS}$ of all barrier structures 5 are randomly distributed between $L_{BS}^{short}$ and $L_{BS}^{long}$, and said barrier structures 5 are randomly arranged at the positions 6a-6c in random sequences.

However, as a border condition, an overlap of intermediate regions 7 should not be allowed for neighboring positions 6a-6c, and preferably should not be allowed for any positions 6a-6c (as shown here). Please note that in case of long enough (average) lengths $L_{BS}$ as compared to the length $L_{IR}$, for example for (average) $L_{BS} \geq 50*L_{IR}$, an overlap of intermediate regions 7 for neighboring positions 6a-6c in random arrangements becomes so rare that it does not need to be considered any more.

A random arrangement of barrier structures 5 along the tape type superconductor 1, as shown for example in Fig. 4 (see above) and Fig. 5 (see below), may help to prevent congeneric behavior at different sections of the tape type superconductor 1 which may add up or cause self-enforcing effects, in particular resulting in a quench or the built up of undesired magnetic field components. This is particularly true if the tape type superconductor 1 is wound in such a way that sections of the tape type superconductor 1 are arranged neighboring in width direction WD and/or neighboring in a direction perpendicular to the tape plane (i.e. one above the other section).

**Fig. 5** illustrates in a top view a fifth embodiment of the inventive tape type superconductor 1.

In this embodiment, the barrier structures 5 have a uniform length $L_{BS}$ in longitudinal direction LD and are distributed equally over five positions 6a-6e (i.e. m=5) in width direction WD, with said positions 6a-6e also being equally distributed along the width direction WD.

In the example shown, each barrier structure 5 has an overlap with two other barrier structures 5a, 5b, with each of the other barrier structures 5a, 5b overlapping with half of the length of said barrier structure 5 at the end and at the front, respectively. As a result, an average barrier density ABD=2 is established.

Along the longitudinal direction LD, for a given barrier structure 5, the position 6a-6e at which the next overlapping barrier structure 5b is located is randomly chosen from the positions which are unequal to the positions of said barrier structure 5 and the previous barrier structure 5a. For example, for said barrier structure 5 marked in Fig. 5 at position 6e, which has a previous barrier structure 5a at position 6d, the next barrier structure 5b may be chosen among positions 6a, 6b and 6c, and in the example shown, the next barrier structure 5b happens to be located at position 6c.

As a consequence of the random arrangement of barrier structures 5, barrier structures 5 at the same width position 6a-6e and subsequent in longitudinal direction LD are separated by intermediate regions 7, with the intermediate regions 7 having random extensions in longitudinal direction.

When the number m of available positions 6a-6e is relatively big as compared to ABD, for example with m>2*ABD or with m≥(ABD+2), and here with m=2.5*ABD or m=ABD+3, respectively, a particularly large variety of possible (random) arrangements of the barrier structures 5 is available. In this case, congeneric behavior and self-enforcing effects are even less likely.

In the illustrated example, approximately $L_{BS}=0.67*W_{SL}$ applies; note that for relatively big m as compared to ABD, relatively short lengths $L_{BS}$ of the barrier structures 5 are preferred, for example with $L_{BS} \leq 2*W_{SL}/(ABS+1)$.

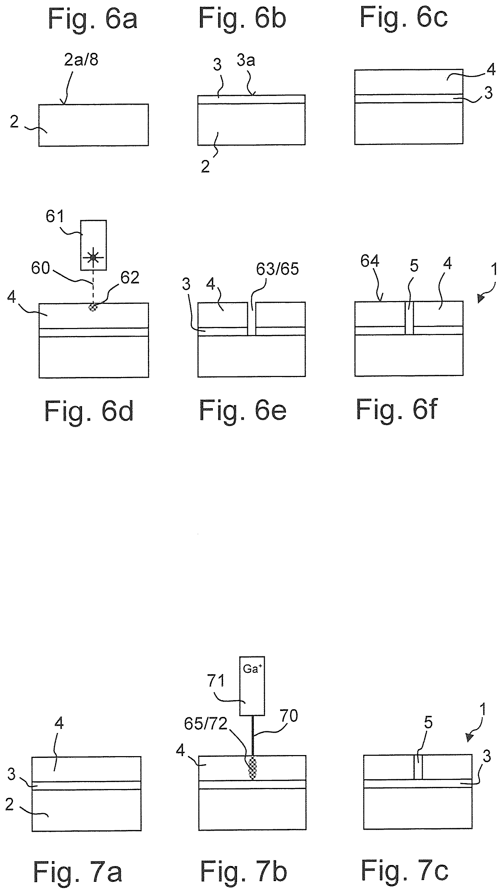

**Figs. 6a-6f** illustrate a first variant of a method for producing an inventive tape type superconductor; in each case, cross-sections perpendicular to the longitudinal direction are shown.

The method starts with a substrate tape 2, for example a steel substrate or a Hastelloy substrate, polished at its surface 2a of the flat side 8, see **Fig. 6a.** On its surface 2a, at least one continuous buffer layer 3 is deposited then, see **Fig. 6b.** On the surface 3a of the (uppermost) buffer layer 3, a continuous superconductor layer 4 is deposited, see **Fig. 6c.**

Then at locations intended for barrier structures, a laser beam 60 originating from a laser device 61 is applied, compare **Fig. 6d.** The laser beam 60 strongly heats and etches away superconducting material close to the laser spot 62, what results in a groove 63 in the superconductor layer 4, and here also in the buffer layer 3, compare **Fig. 6e.** The space 65 of the groove 63 is then filled with material, here with a non-superconducting metal such as gold or silver, resulting in a barrier structure 5, compare **Fig. 6f.** Then the tape type superconductor 1 is finished. Note that typically a protection layer or shunt layer is further deposited on the combined surface 64 of the superconductor layer 4 and the barrier structure 5 (not shown).

Please note that in Fig. 6f only one barrier structure 5 is included in the cross-section for simplicity, but the tape type superconductor 1 may include other numbers of barrier structures 5 or other arrangements than shown.

In the second variant of a method for producing a tape type superconductor shown in **Fig. 7a-7c,** first a semi-finished product with a substrate tape 2, at least one continuous buffer layer 3 and a continuous superconductor layer 4, here of YBCO, is produced (see also Figs. 6a-6c above), compare **Fig. 7a.** Then at locations intended for barrier structures, a beam 70 of gallium ions (Ga+) is directed, with the gallium ions being provided by an ion gun 71, compare **Fig. 7b.** Note that said ion bombardment should be done under vacuum conditions. In a region 72, the material of the superconductor layer 4 is enriched with gallium, thus locally changing the chemical composition in the corresponding space 65. In the region 72, the superconducting characteristics get lost, what results in a barrier structure 5 of non-superconducting material in the tape type superconductor 1, compare **Fig. 7c.**

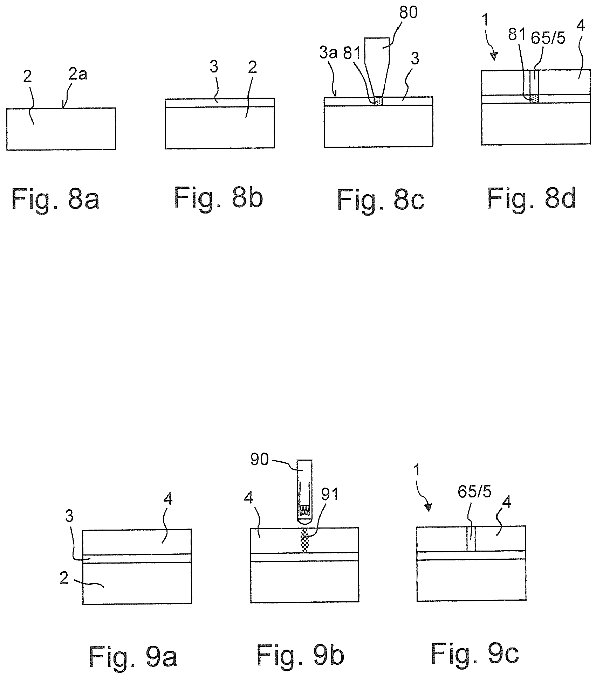

**Figs. 8a-8d** illustrate a third variant of a method for producing a tape type superconductor.

On a polished surface 2a of a substrate tape 2, see **Fig. 8a,** a continuous buffer layer 3 is deposited, see **Fig. 8b.** The surface 3a of said buffer layer 3 is then locally scratched with a scratching tool 80 at locations intended for barrier structures, thus forming a disturbance pattern 81 on or in the buffer layer 3, see **Fig. 8c.** This is followed by depositing material, here components for YBCO, on the patterned surface 3a, see **Fig. 8d.** Above the disturbance pattern 81, material growth results in non-superconducting (or poorly superconducting) material in a space 65 forming a barrier structure 5, and lateral of the disturbance pattern 81, superconducting material, here YBCO, of the superconductor layer 4 grows.

Note that in the tape type superconductor 1, the elemental composition of the material of the superconductor layer 4 and the barrier structure 5 are identical here, but the disturbance pattern 81 causes a different phase composition and/or a different crystallinity, resulting in different characteristics with respect to superconductivity.

It should be noted that instead of scratching (or otherwise disturbing) the surface 3a of the buffer layer 3, also the polished surface 2a of the substrate tape 2 may be scratched (or otherwise disturbed). The buffer layer (or layers) deposited on top can carry on this disturbance pattern to the surface 3a of the buffer layer 3 then, also resulting in a superconductor layer 4 and barrier structures 5 upon material deposition.

In the fourth variant of a method for producing a tape type superconductor shown in **Fig. 9a-9c,** first a semi-finished product with a substrate tape 2, at least one continuous buffer layer 3 and a continuous superconductor layer 4, here of YBCO, is produced (see also Figs. 6a-6c above), compare **Fig. 9a.** Then at locations intended for barrier structures, the material of the superconductor layer 4 is locally heated by means of a heating device 90, compare **Fig. 9b.** In a region 91, the superconducting material of the superconductor layer 4 degrades and becomes non-superconductive, for example by a non-reversible phase transition. This results in a barrier structure 5 of non-superconducting material in the corresponding space 65 in the tape type superconductor 1, compare **Fig. 9c.**

In the illustrated variant, the elemental composition of the originally superconducting material of the superconductor layer 4 does not change upon the heat treatment. However, in another variant, very strong heating may lead to a thermolysis, with elements evaporating into the surrounding; in this case the elemental composition will change in the space 65 or the barrier structure 5 as compared to the superconductor layer 4.

In summary, the invention proposes a tape type superconductor with a plurality of barrier structures within its superconductor layer. The barrier structures are much shorter than the total length of the tape type superconductor, and the barrier structures are arranged subsequent in longitudinal direction, to which they are parallel. At a particular position in width direction, numerous barrier structures, typically 10 or more, often 100 or more, are arranged subsequently in longitudinal direction, but separated from each other by superconducting intermediate regions. The barrier structures are arranged at at least one position in width direction, but there may be a plurality of positions in width direction over which the barrier structures are distributed. The barrier structures may be distributed in a pattern periodic in longitudinal direction, or may be arranged in a random pattern. The barrier structures are non-superconducting or worse superconducting as compared to the superconductor layer. The separated barrier structures allow for a decoupling of regions in the superconductor layer, but all regions of the superconductor layer are still interconnected superconductingly. This reduces unwanted induced magnetization, without a substantial reduction of the critical current. Inventive tape type superconductors may be used in spools, magnet coils, in particular for NMR magnets, for motors or generators, transformers, fault current limiters or cables, for example.

List of reference signs

| | |
|---|---|
| 1 | tape type superconductor |
| 2 | substrate tape |
| 2a | surface (substrate tape) |
| 3 | buffer layer |
| 3a | surface (buffer layer) |
| 4 | superconductor layer |
| 5, 5a, 5b | barrier structures |
| 6a-6e | positions |
| 7 | intermediate region |
| 8 | flat side (substrate tape) |
| 60 | laser beam |

| 61 | laser device |
|----|----|
| 62 | laser spot |
| 63 | groove |
| 64 | surface (combined superconductor layer and barrier structure) |
| 65 | space |
| 70 | beam of ions |
| 71 | ion gun |
| 72 | region (affected by ions) |
| 80 | scratching tool |
| 81 | disturbance pattern |
| 90 | heating device |
| 91 | region (affected by heating) |
| ABD | average barrier density |
| HD | height direction |
| $H_{SL}$ | height of superconductor layer |
| $L_{BS}$ | length of barrier structure |
| $L_{BS}^{long}$ | length of longest barrier structure |
| $L_{BS}^{short}$ | length of shortest barrier structure |
| LD | longitudinal direction |
| $L_{IR}$ | length of intermediate region |
| $L_{TTS}$ | length of tape type superconductor |
| P | period |
| WD | width direction |
| $W_{BS}$ | width of a barrier structure |
| $W_{SL}$ | width of superconductor layer |

**Claims**

1. A tape type superconductor (1), extending along a longitudinal direction (LD), comprising

   - a substrate tape (2),
   - at least one buffer layer (3), and
   - a superconductor layer (4),

   said superconductor layer (4) having a width $W_{SL}$ in a width direction (WD),
   with the width direction (WD) being perpendicular to the longitudinal direction (LD) and being parallel to a substrate tape (2) flat side (8),
   and said tape type superconductor (1) having a length $L_{TTS}$ in longitudinal direction (LD),
   **characterized in**
   **that** the tape type superconductor (1) comprises a plurality of elongated barrier structures (5, 5a, 5b) which are oriented in parallel with the longitudinal direction (LD),
   wherein a respective barrier structure (5, 5a, 5b) has a length $L_{BS}$ in longitudinal direction (LD),
   with $L_{BS} \geq 0.20*W_{SL}$ and $L_{BS} \leq 0.20*L_{TTS}$,
   **that** the barrier structures (5, 5a, 5b) are arranged distributed along the longitudinal direction (LD),
   and **that** the barrier structures (5, 5a, 5b) are located at least partially in the superconductor layer (4) and impede a superconducting current flow in width direction (WD) across a respective barrier structure (5, 5a, 5b).

2. A tape type superconductor (1) according to claim 1, **characterized in that** a respective barrier structure (5, 5a, 5b) stretches across the complete height $H_{SL}$ of a the superconductor layer (4) in a height direction (HD), with the height direction (HD) being perpendicular to the longitudinal (LD) direction and being perpendicular to the substrate tape (2) flat side (8).

3. A tape type superconductor (1) according to claim 1 or 2, **characterized in that** the barrier structures (5, 5a, 5b) are non-superconducting or exhibit a critical current density $j_c^{BS}$ in width direction (WD) which is less than 1/100 of a critical current density $j_c^{SL}$ in width direction (WD) of a superconducting material of the superconductor layer (4).

4. A tape type superconductor (1) according to one of the claims 1 through 3, **characterized in that** the barrier structures (5, 5a, 5b) are spaces (65) filled with a non-superconducting material of a different chemical composition as compared to the superconducting material of the superconductor layer (4), in particular wherein the spaces (65) are filled with a non-superconducting metal.

5. A tape type superconductor (1) according to one of the claims 1 through 3, **characterized in that** the barrier structures (5, 5a, 5b) have the same chemical composition as the superconducting material of the superconductor layer (4), but exhibit deviations from the phase composition and/or exhibit disturbances in the crystalline structure as compared to the superconducting material of the superconductor layer (4).

6. A tape type superconductor (1) according to one of the preceding claims, **characterized in that** at least 80%, preferably at least 90%, of the length $L_{TTS}$ of the tape type superconductor (1) is overlapped by barrier structures (5, 5a, 5b).

7. A tape type superconductor (1) according to one of the preceding claims, **characterized in that** at least 80%, preferably at least 90%, of the length $L_{TTS}$ of the tape type superconductor (1) is overlapped by at least n barrier structures (5, 5a, 5b) which are sequent in width direction, with $n \geq 2$.

8. A tape type superconductor (1) according to one of the preceding claims, **characterized in that** for an average barrier density ABD, which is defined as a local barrier density of the tape type superconductor (1) averaged along the complete length $L_{TTS}$, with the local barrier density being the number of barrier structures (5, 5a, 5b) intersected by a cross section of the tape type superconductor (1) perpendicular to the longitudinal direction (LD) at a local position in longitudinal direction (LD), the following applies

$$ABD \geq 0.80,$$

preferably ABD > 1.0,
most preferably $ABD \geq 2.0$.

9. A tape type superconductor (1) according to claim 8, **characterized in that**

   • $ABD \leq 2.5$ and $W_{SL} / (2*ABD) \leq L_{BS}$, and/or
   • $ABD \leq 250$ and $L_{BS} \leq (50 / ABD)*W_{SL}$, and/or
   • $ABD \leq 5$ and $W_{SL} / ABD \leq L_{BS}$, and/or
   • $ABS \leq 125$ and $L_{BS} \leq (25 / ABD)*W_{SL}$.

10. A tape type superconductor (1) according to claim 8 or 9, **characterized in that** the barrier structures (5, 5a, 5b) are arranged distributed over at least m different positions (6a-6e) in width direction (WD), with m>2*ABD or m>3*ABD, in particular wherein on average over the length $L_{TTS}$, the barrier structures (5, 5a, 5b) are basically equally distributed over the at least m different positions (6a-6e) in width direction (WD).

11. A tape type superconductor (1) according to one of the preceding claims, **characterized in that** the superconducting material of the superconductor layer (4) is a high temperature superconductor, in particular REBCO or BiSCCO or $MgB_2$.

12. Method for producing a tape type superconductor (1) according to claim 4, **characterized in that**

   - at least one continuous buffer layer (3) is deposited on the substrate tape (2),
   - a continuous superconductor layer (4) is deposited on the at least one continuous buffer layer (3),
   - at locations intended for barrier structures (5, 5a, 5b), the superconducting material of the superconductor layer (4) is locally removed, in particular by laser etching, thus forming grooves (63) reaching at least to the at least one buffer layer (3),
   - and the grooves (63) are filled with the non-superconducting material of a different chemical composition as compared to the superconducting material of the superconductor layer (4).

13. Method for producing a tape type superconductor (1) according to claim 4, **characterized in that**

- at least one continuous buffer (3) layer is deposited on the substrate tape (2),
- a continuous superconductor layer (4) is deposited on the at least one continuous buffer layer (3),
- at locations intended for barrier structures (5, 5a, 5b), the superconducting material of the superconductor layer (4) is locally converted into the non-superconducting material of a different chemical composition as compared to the superconducting material of the superconductor layer (4), in particular by ion bombardment.

14. Method for producing a tape type superconductor (1) according to claim 5, **characterized in that**

- at locations intended for barrier structures (5, 5a, 5b),

a) a surface (3a) of a buffer layer (3) deposited on the substrate tape (2) is locally disturbed, in particular by scratching or laser etching, thus forming a disturbance pattern (81), or
b) a surface (2a) of a substrate tape (2) is locally disturbed, in particular by scratching or laser etching, thus forming a disturbance pattern (81), and a buffer layer (3) is deposited on the substrate tape (2),

- and material is deposited on the buffer layer (3), wherein the superconducting material of the superconductor layer (4) forms everywhere on the buffer layer (3) but on the disturbance pattern (81).

15. Method for producing a tape type superconductor (1) according to claim 5, **characterized in that**

- at least one continuous buffer (3) layer is deposited on the substrate tape (2),
- a continuous superconductor layer (4) is deposited on the at least one continuous buffer layer (3),
- at locations intended for barrier structures (5, 5a, 5b), the superconducting material of the superconductor layer (4) is locally treated, imposing a new phase composition and/or disturbances in the crystalline structure without changing the chemical composition, in particular by local heating.

Fig. 1a

Fig. 1b

Fig. 1c

Fig. 2a

Fig. 2b

Fig. 2c

Fig. 2d

## Fig. 3

## Fig. 4

## Fig. 5

Fig. 6a Fig. 6b Fig. 6c

Fig. 6d Fig. 6e Fig. 6f

Fig. 7a Fig. 7b Fig. 7c

EP 3 540 795 A1

Fig. 8a    Fig. 8b    Fig. 8c    Fig. 8d

Fig. 9a    Fig. 9b    Fig. 9c

Europäisches
Patentamt

European
Patent Office

Office européen
des brevets

# EUROPEAN SEARCH REPORT

Application Number

EP 18 16 1977

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | US 2005/139380 A1 (KNOLL ALLAN R [US] ET AL) 30 June 2005 (2005-06-30)<br>* paragraphs [0018] - [0042]; figures 1,7 *<br> | 1-4,6-9, 11,12<br>5,13-15<br>10 | INV.<br>H01L39/14<br>H01L39/24 |
| Y | US 2008/004184 A1 (OHMATSU KAZUYA [JP]) 3 January 2008 (2008-01-03)<br>* paragraphs [0043] - [0049] * | 5,15 | |
| Y | EP 0 296 973 A2 (SUMITOMO ELECTRIC INDUSTRIES [JP]) 28 December 1988 (1988-12-28)<br>* page 3, line 33 - page 4, line 40 * | 13 | |
| Y,D | US 2017/287599 A1 (KURIHARA CHIHAYA [JP]) 5 October 2017 (2017-10-05)<br>* paragraphs [0047] - [0082]; figure 1 * | 14 | |

**TECHNICAL FIELDS
SEARCHED (IPC)**

H01L

The present search report has been drawn up for all claims

| Place of search | Date of completion of the search | Examiner |
|---|---|---|
| Munich | 21 September 2018 | Steiner, Markus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 16 1977

This annex lists the patent family members relating to the patent documents cited in the above-mentioned European search report.
The members are as contained in the European Patent Office EDP file on
The European Patent Office is in no way liable for these particulars which are merely given for the purpose of information.

21-09-2018

| Patent document cited in search report | | | Publication date | Patent family member(s) | | | Publication date |
|---|---|---|---|---|---|---|---|
| US 2005139380 | A1 | | 30-06-2005 | AT | 527700 | T | 15-10-2011 |
| | | | | CA | 2550395 | A1 | 29-09-2005 |
| | | | | CN | 101164175 | A | 16-04-2008 |
| | | | | DK | 1769542 | T3 | 06-02-2012 |
| | | | | EP | 1769542 | A2 | 04-04-2007 |
| | | | | ES | 2377478 | T3 | 28-03-2012 |
| | | | | JP | 5414973 | B2 | 12-02-2014 |
| | | | | JP | 2007524198 | A | 23-08-2007 |
| | | | | KR | 101429022 | B1 | 11-08-2014 |
| | | | | KR | 20060110324 | A | 24-10-2006 |
| | | | | US | 2005139380 | A1 | 30-06-2005 |
| | | | | WO | 2005089095 | A2 | 29-09-2005 |
| US 2008004184 | A1 | | 03-01-2008 | AU | 2006293313 | A1 | 29-03-2007 |
| | | | | CA | 2587969 | A1 | 29-03-2007 |
| | | | | CN | 101069248 | A | 07-11-2007 |
| | | | | EP | 1933335 | A1 | 18-06-2008 |
| | | | | HK | 1107871 | A1 | 09-04-2010 |
| | | | | JP | 4984466 | B2 | 25-07-2012 |
| | | | | JP | 2007087734 | A | 05-04-2007 |
| | | | | KR | 20080046134 | A | 26-05-2008 |
| | | | | NZ | 555225 | A | 25-06-2010 |
| | | | | RU | 2007118697 | A | 27-11-2008 |
| | | | | TW | 200721200 | A | 01-06-2007 |
| | | | | US | 2008004184 | A1 | 03-01-2008 |
| | | | | WO | 2007034686 | A1 | 29-03-2007 |
| EP 0296973 | A2 | | 28-12-1988 | CA | 1331951 | C | 13-09-1994 |
| | | | | DE | 3889015 | D1 | 19-05-1994 |
| | | | | DE | 3889015 | T2 | 13-10-1994 |
| | | | | EP | 0296973 | A2 | 28-12-1988 |
| | | | | HK | 164595 | A | 27-10-1995 |
| | | | | JP | 2713343 | B2 | 16-02-1998 |
| | | | | JP | H0198278 | A | 17-04-1989 |
| US 2017287599 | A1 | | 05-10-2017 | CN | 106961829 | A | 18-07-2017 |
| | | | | EP | 3367394 | A1 | 29-08-2018 |
| | | | | JP | 6201080 | B1 | 20-09-2017 |
| | | | | JP | WO2017077788 | A1 | 02-11-2017 |
| | | | | US | 2017287599 | A1 | 05-10-2017 |
| | | | | WO | 2017077788 | A1 | 11-05-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070191202 A1
- EP 2490273 A1
- EP 2144255 A1

- US 9786415 B2
- US 20170287599 A1
- DE 102009038920 A1